# FASCICULE DE BREVET EUROPEEN

(11) **EP 3 375 092 B1**
(45) Date de publication et mention de la délivrance du brevet: **04.09.2019**
(21) Numéro de dépôt: 16793826.5
(22) Date de dépôt: 04.11.2016
(51) Int. Cl.: H03K 5/1534, H03M 1/66, H03K 5/00

(54) **PROCÉDÉ DE SYNCHRONISATION DE CONVERTISSEURS DE DONNÉES PAR UN SIGNAL TRANSMIS DE PROCHE EN PROCHE**
VERFAHREN ZUR SYNCHRONISATION EINES DATENWANDLERS MITHILFE EINES IM NAHFELD ÜBERTRAGENEN SIGNALES
METHOD FOR THE SYNCHRONISATION OF DATA CONVERTERS BY A SIGNAL TRANSMITTED IN CLOSE PROXIMITY

(30) Priorité: 10.11.2015 FR 1560739
(43) Date de publication de la demande: 19.09.2018
(73) Titulaire: Teledyne e2v Semiconductors SAS, 38120 Saint-Egrève (FR)
(72) Inventeur: BOUIN, Etienne, 38190 Brignoud (FR); LAUBE, Rémi, 38113 Veurey-voroize (FR); LIGOZAT, Jérôme, 38000 Grenoble (FR); STACKLER, Marc, Shenzhen 518054 (CN)
(74) Mandataire: Desvignes, Agnès
(86) Numéro de dépôt international: PCT/EP2016/076689
(87) Numéro de publication internationale: WO 2017/080925

(56) Documents cités:
- EP-A1- 0 798 863
- DE-A1-102004 050 648
- "Synchronizing Multiple High-Speed Multiplexed DACs for Transmit Applications", INTERNET CITATION, 21 septembre 2006 (2006-09-21), pages 1-6, XP002492319, Extrait de l'Internet: URL:http://www.maxim.ic.com/an3901 [extrait le 2008-08-14]

## Description

### DOMAINE TECHNIQUE

L'invention concerne la synchronisation de convertisseurs de données analogique-numérique et/ou numérique-analogique. Elle concerne plus particulièrement les convertisseurs rapides dont la fréquence de travail est de l'ordre d'une centaine de mégahertz et plus. L'invention s'applique notamment à des systèmes qui nécessitent la synchronisation de plusieurs de ces convertisseurs rapides, comme par exemple les réseaux d'antennes ou les systèmes de communication de données à modulation I/Q.

### PROBLEME TECHNIQUE

Les convertisseurs rapides sont généralement formés de deux ou plusieurs coeurs de convertisseurs qui travaillent chacun à une fréquence de travail (d'échantillonnage) plus lente, et dont on combine les signaux de sortie (entrelacement) pour arriver à la fréquence de conversion attendue. Les horloges d'échantillonnage de ces convertisseurs sont ainsi habituellement générées en interne par un générateur d'horloge qui effectue une division de fréquence, à partir de l'horloge de référence. Si on a n coeurs de conversion par convertisseur, la fréquence d'échantillonnage est obtenue à partir de l'horloge de référence CLK par division de fréquence par n.

Dans une architecture comportant plusieurs convertisseurs, il est nécessaire de pouvoir les synchroniser, pour les faire démarrer en phase. Dans le cas de convertisseurs rapides, il s'agit de faire démarrer en phase les diviseurs de fréquence, c'est-à-dire qu'il ne suffit pas de dire qu'on les réinitialise de manière synchrone sur un front actif d'horloge de référence, encore faut-il savoir sur quel front actif, sinon les horloges d'échantillonnage obtenues pourront ne pas être toutes en phase selon que les diviseurs de fréquence démarreront sur un front actif d'horloge ou le suivant.

Une des solutions connues à ce problème est d'utiliser un signal, que l'on appelle habituellement signal de synchronisation, qui est une impulsion distribuée en phase sur tous les convertisseurs et sa distribution est conçue pour obtenir le temps de propagation adapté pour chaque convertisseur, pour que les fronts actifs d'horloge sur lesquels les diviseurs de fréquence seront initialisés se correspondent, c'est-à-dire que deux à deux ces fronts actifs seront tous distants d'un nombre de périodes horloge de référence qui est un multiple de n : 0, n, 2xn, .... Tout est déterminé par conception des chemins de distribution de l'horloge de référence et du signal de synchronisation sur chacun des convertisseurs.

Cette technique nécessite ainsi une distribution très soignée de l'horloge de référence et du signal de synchronisation qui repose sur une évaluation précise des délais de propagation dans les chemins de conduction électriques amenant ces signaux sur chacun des convertisseurs dans une architecture donnée. Il s'agit de prendre en compte tous les paramètres influant la propagation : longueur et matériaux des conducteurs, caractéristiques des étages d'entrée et de sortie des signaux, caractéristiques des soudures, .... Si on sait concevoir cela plutôt bien aux faibles fréquences, dans les systèmes rapides qui nous occupent avec des fréquences de travail de 100 mégahertz et plus, la tâche est plus délicate. Notamment il y a alors une forte contrainte supplémentaire concernant l'acquisition du signal de synchronisation qui doit intervenir dans une fenêtre temporelle très inférieure à la période d'horloge. Toutes ces difficultés s'ajoutent et rendent coûteuse mais également difficile une synchronisation par conception qui soit suffisamment précise. Cela se traduit au niveau du système par de la complexité système supplémentaire et des performances dégradées.

D'autres solutions connues n'utilisent pas ce signal de synchronisation. Ce sont par exemple des solutions utilisant des boucles à verrouillage de phase PLL dans les convertisseurs, comme décrit par exemple dans le document publié sur Internet : *"*Synchronizing Multiple High-Speed Multiplexed DACs for Transmit applications", XP002492319, 21 sept. 2006, pp 1-6, url=http://www.maxim.ic.com/an3901. Mais elles posent d'autres problèmes. En particulier, elles amènent généralement des problèmes de gigue sur les horloges d'échantillonnage, ce qui impacte également les performances des convertisseurs. Ces solutions à PLL posent également des problèmes de stabilité en température, sans compter la complexité qu'elles ajoutent dans chaque convertisseur.

### RESUME DE L'INVENTION

L'invention se propose de résoudre le problème technique relatif à la distribution du signal de synchronisation. On cherche une solution plus simple de mise en oeuvre y compris lorsqu'il faut synchroniser un grand nombre de convertisseurs sur une horloge à haute fréquence, par exemple 100 mégahertz et au-delà, avec toute la précision requise.

Dans une architecture donnée, les délais de propagation d'un signal d'un point à un autre sont fixés par les caractéristiques physiques du chemin de propagation de ce signal dans l'architecture considérée. Plutôt que d'agir en amont, à la conception, pour fixer ce délai pour chaque convertisseur comme dans l'art antérieur, l'idée astucieuse de l'invention est de configurer les convertisseurs en au moins une chaine série, et de remplacer la distribution en phase du signal de synchronisation sur tous les convertisseurs, par une transmission de ce signal d'un convertisseur vers un autre pour atteindre de proche en proche tous les convertisseurs d'une chaine, en combinaison avec un paramétrage de chaque convertisseur de la chaine, qui reflète les délais de propagation du signal de synchronisation dans cette chaine de convertisseurs et par lequel on transmet en sortie de chaque convertisseur, un signal de synchronisation qui est resynchronisé, pour le convertisseur suivant. Dans chaque convertisseur, le paramétrage permet également de choisir le bon front actif d'horloge de référence qui récupère le signal réinitialisant le générateur d'horloge d'échantillonnage, permettant de synchroniser en phase les horloges d'échantillonnage de tous les convertisseurs.

De cette façon, on relâche les contraintes en amont, sur la conception et la réalisation des circuits applicatifs, donc on réduit les coûts. Et on réalise une synchronisation performante des convertisseurs, au prix d'une étape d'apprentissage de paramètres de configuration de la synchronisation, d'implémentation aisée, dont on montre qu'elle n'est à réaliser qu'une seule fois, et de l'ajout d'éléments de logique séquentielle et combinatoire dans chaque convertisseur, permettant de déterminer et d'appliquer le paramétrage.

L'invention concerne ainsi un procédé de synchronisation de convertisseurs de données de type numérique/analogique et/ou analogique/numérique sur un front actif d'une horloge de référence CLK commune, caractérisé en ce que les convertisseurs forment au moins une chaine de transmission série d'un signal de synchronisation émis par une unité de commande des convertisseurs tel que :
- le convertisseur de rang 1 dans la chaine a une entrée de synchronisation connectée à une sortie de commande de synchronisation de l'unité de commande ;
- chaque convertisseur de rang j supérieur à 1 dans la chaine a une entrée de synchronisation connectée à la sortie de synchronisation du convertisseur de rang j-1 dans la chaine ;
le procédé de synchronisation étant caractérisé en ce qu'un processus de synchronisation des convertisseurs de la chaine sur un front actif d'horloge de référence CLK activé par l'unité de commande comprend les étapes suivantes pilotées par l'unité de commande:
- initialisation dans chaque convertisseur d'un registre de configuration de la synchronisation comportant au moins un paramètre de polarité définissant comme polarité d'un front d'horloge de référence pour la détection de signal en entrée de synchronisation du convertisseur, la polarité du front actif d'horloge de référence ou la polarité inverse; puis
- émission sur la sortie de commande synchronisation de l'unité de commande d'un signal de synchronisation, qui est une impulsion de largeur au moins égale à une période d'horloge de référence;
le procédé de synchronisation étant encore caractérisé en ce que chaque convertisseur dans la chaine est configuré pour réaliser les étapes suivantes:
- a) détection d'un signal de synchronisation en entrée de synchronisation, sur un front d'horloge de référence CLK qui a la polarité définie par la valeur dudit paramètre de polarité configuré dans le convertisseur,
- b) alignement sur le front actif d'horloge de référence suivant du signal détecté à l'étape a) pour fournir un signal de synchronisation aligné sur un front actif d'horloge de référence et application dudit signal sur la sortie de synchronisation du convertisseur.

Dans une mise en oeuvre, chaque convertisseur dans la chaine est formé de n coeurs de conversion à une fréquence d'échantillonnage qui est fournie par un diviseur par n de la fréquence d'horloge de référence, où n est un entier non nul, et configuré pour réaliser à la suite de l'étape b), les étapes suivantes :
- c) décalage dudit signal de synchronisation aligné obtenu à l'étape b) par un nombre entier de période(s) d'horloge de référence défini par la valeur d'un paramètre de phase fourni par ledit registre de configuration du convertisseur ; et
-d) application du signal décalé obtenu comme signal de réinitialisation dudit diviseur de fréquence par n,
où ledit nombre entier défini par le paramètre de phase a une valeur comprise entre 0 et n-1, bornes incluses.

Chaque convertisseur dans la chaine est configuré pour réaliser une étape e) de vérification de la stabilité d'un niveau actif de signal reçu en entrée de synchronisation acquis sur le front d'horloge de référence défini à l'étape a) de détection par la valeur dudit paramètre de polarité, par comparaison de la première valeur acquise sur ledit front de détection, à au moins une deuxième valeur dudit signal acquise sur un front en avance, d'un délai déterminé, sur ledit front de détection et à au moins un troisième valeur dudit signal acquise sur un front en retard, d'un délai déterminé, sur ledit front de détection, et si les valeurs ne sont pas toutes identiques, activation d'un bit drapeau correspondant dans ledit registre de configuration du convertisseur.

Le procédé comprend une phase d'apprentissage permettant la configuration du paramètre de polarité de chaque convertisseur successivement depuis le premier convertisseur en entrée de chaine, jusqu'au dernier convertisseur de la chaine, au moyen du bit drapeau du registre de configuration des convertisseurs, puis la configuration d'une valeur p du paramètre de phase de chaque convertisseur, à partir d'une détermination du nombre entier M de périodes horloge de référence séparant le front d'impulsion de synchronisation en sortie du convertisseur du front d'impulsion de synchronisation en sortie d'un convertisseur en amont dans la chaine, et la valeur p du paramètre de phase est telle que la somme M+p est un multiple de n.

L'invention concerne également un convertisseur de données analogique/numérique ou numérique/analogique qui comprend une entrée pour recevoir un signal de synchronisation et un circuit de synchronisation associé permettant la synchronisation du convertisseur sur un front actif d'un signal d'horloge de référence, selon le procédé de l'invention.

D'autres caractéristiques et avantages de l'invention sont présentés dans la description suivante, en référence aux dessins annexés dans lesquels :
- la figure 1 illustre une architecture de données dans laquelle les convertisseurs sont configurés pour former une chaine de propagation série d'un signal de synchronisation selon l'invention ;
- la figure 2 est un schéma bloc simplifié d'un convertisseur comprenant les éléments de circuit pour la mise en oeuvre d'un procédé de synchronisation dans une chaine de convertisseurs selon l'invention ;
- les figures 3 et 4 illustrent des chronogrammes des signaux générés dans chaque convertisseur, en fonction des paramètres de configuration de la synchronisation selon l'invention ;
- la figure 5 est un chronogramme qui illustre plus particulièrement l'alignement en phase des horloges d'échantillonnage dans une chaine de convertisseurs selon le procédé de l'invention ;
- les figures 6 et 7 sont un chronogramme des signaux et un synoptique des étapes d'un processus d'apprentissage selon l'invention, pour configurer le paramètre de polarité de chaque convertisseur, utilisant un signal de synchronisation émis par l'unité de commande qui est synchrone de l'horloge de référence ;
- les figures 8 et 9 illustrent une variante du procédé d'apprentissage utilisant un signal de synchronisation émis par l'unité de commande qui est asynchrone ; et
- les figures 10 et 11 montrent de manière schématique différentes possibilités de constitution de chaine(s) de convertisseurs compatibles avec un procédé de synchronisation selon l'invention.

### DESCRIPTION DETAILLEE

L'invention s'applique à des systèmes de traitement de données qui comprennent une unité de commande qui pilote un ensemble de convertisseurs de données de type analogique/numérique et/ou numérique/analogique, qui doivent travailler de façon synchrone. Dans ces architectures, l'unité de commande, généralement réalisée par un circuit logique programmable de type FPGA (Field-Programmable-Gate Array), est conçue pour piloter les convertisseurs suivant un schéma de communication maitre-esclave, au moyen d'un bus d'interface périphérique, tel que par exemple le bus appelé bus SPI (pour *Serial Peripheral Interface*) qui est un bus de données série synchrone très utilisé. Le bus d'interface périphérique permet l'échange de données entre l'unité de commande et les convertisseurs, en particulier des données DATA qui sont les données à convertir (convertisseur numérique analogique) ou qui sont le résultat des conversions (convertisseur numérique analogique). Ces aspects ne seront pas détaillés plus avant. Ils sont bien connus de l'homme de l'art.

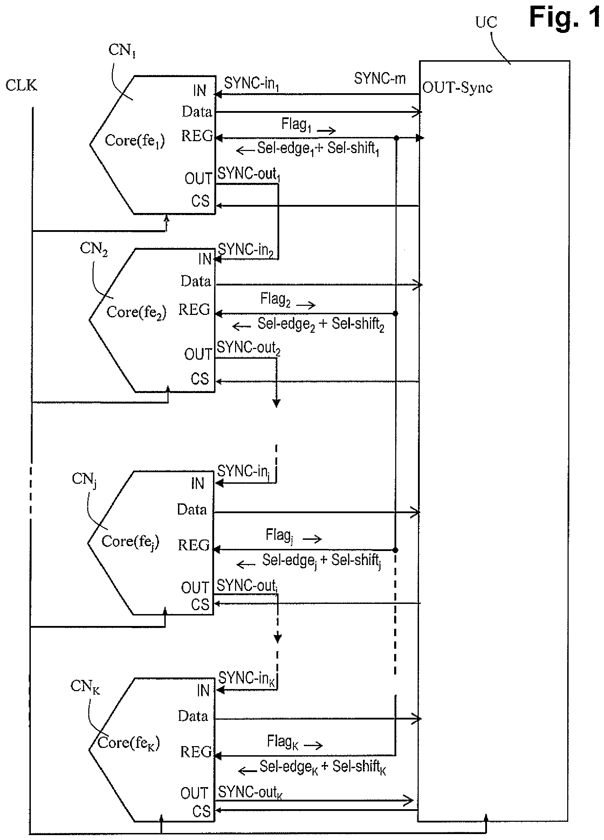

La figure 1 illustre une architecture de traitement comportant K convertisseurs pilotés par une unité de commande UC, qui sont arrangés en une chaine série qui permet leur synchronisation selon l'invention sur une horloge CLK de référence commune. En pratique la distribution électrique de cette horloge sur l'unité de commande et les convertisseurs est effectuée en utilisant les techniques de l'état de l'art, pour en assurer la distribution synchrone sur tous les composants.

Selon l'invention, chaque convertisseur de la chaine est configuré pour recevoir un signal de synchronisation sur une broche d'entrée IN ; et transmettre un signal de synchronisation vers un convertisseur suivant, sur une broche de sortie OUT. La chaine série de distribution du signal de synchronisation sur les convertisseurs selon l'invention peut ainsi être constituée de la façon suivante : un signal de synchronisation SYNC-m est émis par l'unité de commande UC des convertisseurs ; il est appliqué sur le premier convertisseur de la chaîne et transmis après resynchronisation au convertisseur suivant et ainsi de suite jusqu'au dernier convertisseur de la chaine. On note SYNC-inⱼ le signal reçu sur la broche d'entrée IN du convertisseur de rang j dans la chaine ; et SYNC-outⱼ le signal transmis par le convertisseur de rang j sur sa broche de sortie OUT, après détection du signal SYNC-inⱼ et alignement sur un front actif d'horloge de référence comme il va être expliqué dans la suite. Enfin, pour le procédé de synchronisation selon l'invention, l'impulsion de synchronisation a une durée (ou largeur) qui est au moins égale à une période d'horloge CLK, permettant une acquisition du niveau actif du signal de synchronisation par chaque convertisseur sur au moins l'un des deux fronts montant et descendant d'une impulsion d'horloge CLK.

On propose dans la suite de décrire d'abord le processus de synchronisation des convertisseurs selon l'invention, et ensuite les processus de détermination des paramètres de configuration utilisés par ce processus.

Auparavant, il convient de préciser les conventions qui ont été choisies : le front actif d'horloge de référence CLK, sur lequel on réalise la synchronisation est le front montant ; la valeur binaire par défaut des paramètres du registre de configuration de la synchronisation est la valeur nulle (0). Le signal de synchronisation est une impulsion de synchronisation, qui est une impulsion logique positive. La détection d'un tel signal correspond à la détection ou l'acquisition d'un niveau actif, qui est avec la convention choisie, le niveau haut. On saura faire les transpositions et adaptations nécessaires pour des systèmes utilisant des conventions différentes.

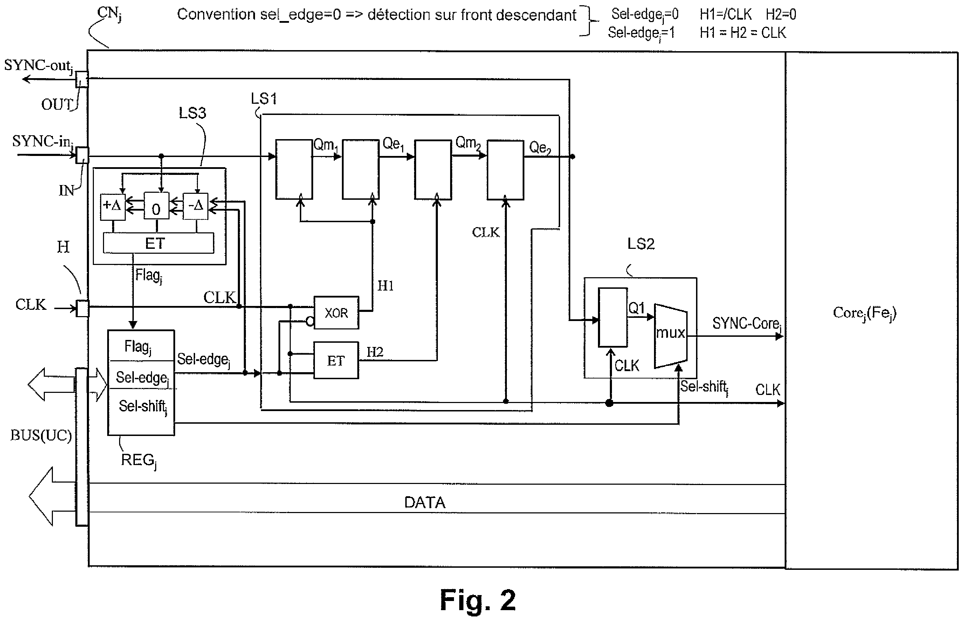

La figure 2 illustre de manière schématique les éléments du circuit de synchronisation et le registre de configuration de synchronisation prévus dans chaque convertisseur, pour la mise en oeuvre de la synchronisation des convertisseurs de la chaine selon le procédé de l'invention.

Le circuit de synchronisation comprend des circuits de logique séquentielle et combinatoire. Un premier circuit LS1 permet d'assurer une fonction de détection et resynchronisation d'un signal de synchronisation SYNC_inⱼ reçu en entrée. Un deuxième circuit LS2 est prévu qui permet d'assurer une fonction de décalage de ce signal, pour permettre le démarrage en phase des diviseurs de fréquence de tous les convertisseurs dans la chaine, lorsque ces convertisseurs sont constitués de coeurs de conversion à fréquence de travail plus lente que la fréquence d'horloge CLK. Les fonctions de ces deux premiers circuits LS1 et LS2 sont réalisées en lien avec les paramètres définis dans le registre REGⱼ de configuration de la synchronisation. Un troisième circuit LS3 permet de détecter si le front d'horloge CLK positionné par le paramètre de polarité est bien le front adéquat. S'il ne l'est pas, il permet d'activer un bit drapeau Flagⱼ prévu dans le registre de configuration, qui est notamment utilisé en phase d'apprentissage, pour justement déterminer la valeur du paramètre de polarité pour le convertisseur considéré.

### CIRCUIT LS1 ET PARAMETRE DE POLARITE

On a vu que le paramètre de polarité Sel-edgeⱼ est celui qui permet de fixer dans chaque convertisseur, la polarité adéquate du front d'horloge CLK utilisé pour faire l'acquisition de manière fiable du niveau actif du signal de synchronisation.

Ce paramètre est utilisé par le premier circuit LS1 de logique séquentielle et combinatoire du convertisseur. Ce circuit LS1 reçoit en entrée le signal de synchronisation Sync-inⱼ reçu sur la broche d'entrée IN. Il fournit en sortie, le signal de synchronisation Sync_outⱼ qui est transmis sur la broche de sortie. Ce circuit LS1 est conçu pour les conventions sur les signaux indiquées précédemment, pour
- détecter une impulsion de synchronisation reçue en entrée, sur un front d'horloge CLK qui peut être le front montant ou le front descendant selon la valeur du paramètre de polarité Sel-edgeⱼ ; et
- fournir en sortie une impulsion de synchronisation qui est synchrone de l'horloge de référence, c'est-à-dire alignée sur le front actif d'horloge, qui pour les conventions retenues est le front montant.

La figure 2 propose un exemple de réalisation de ce circuit, à titre d'illustration. Dans cet exemple, le circuit LS1 comprend deux paires de bascules D commandées en mode maitre esclave, en série.

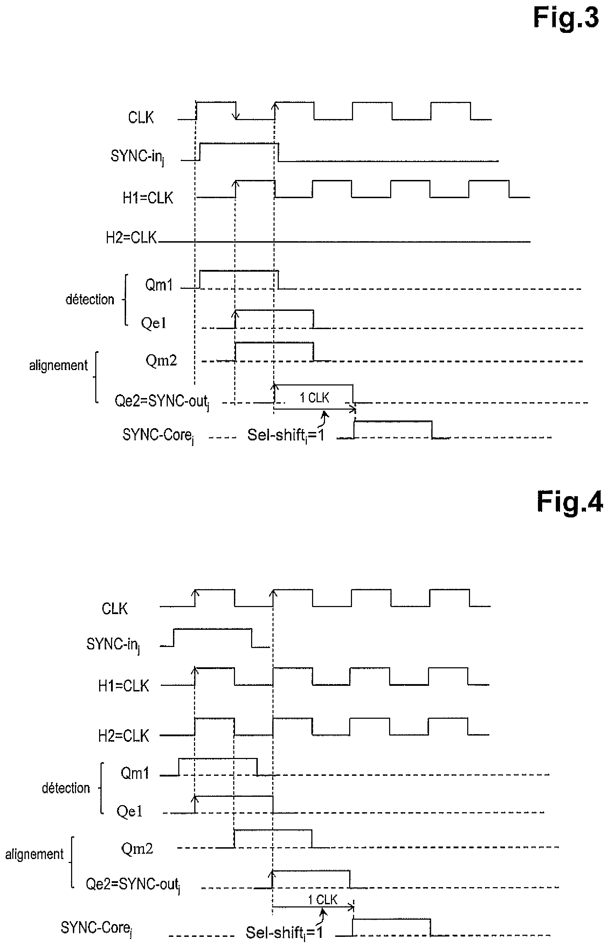

La première paire réalise la fonction de détection. Elle est séquencée par un signal d'horloge H1 qui est généré par une porte logique, dans l'exemple une porte OU Exclusif qui reçoit sur une entrée, le signal d'horloge CLK, et sur l'autre, l'inverse du paramètre de polarité Sel-edgeᵢ. Lorsque Sel-edgeᵢ=0, on a ainsi H1=/CLK. C'est-à-dire que la détection se fait sur un front descendant du signal d'horloge CLK (Figure 3) ; et lorsque Sel-edgeᵢ=1, on a H1 = CLK. C'est-à-dire que la détection se fait sur un front montant du signal d'horloge CLK (Figure 4). Ainsi, la sortie Qm1 de la bascule maitre de la première paire prend la valeur du signal SYNC-inⱼ appliqué en entrée sur (pendant) le niveau bas de l'horloge H1 ; et conserve son état précédent sur le niveau haut ; pour la sortie Qe1 de la bascule esclave de la première paire, c'est le contraire : elle prend la valeur du signal SYNC-inⱼ appliqué en entrée sur (pendant) le niveau haut de l'horloge H1et conserve son état précédent sur le niveau bas.

La deuxième paire réalise la fonction d'alignement sur un front-actif d'horloge CLK suivant. Dans cette deuxième paire, la bascule maître est séquencée par un signal d'horloge H2 qui est généré par une porte logique, dans l'exemple une porte ET qui reçoit sur une entrée, le signal d'horloge CLK, et sur l'autre, le paramètre de polarité Sel-edgeᵢ. Lorsque Sel-edgeᵢ=0, on a ainsi H2=0 (Figure 3) et la sortie Qm2 de cette bascule recopie tout le temps son entrée, c'est-à-dire le signal Qe1 ; et lorsque Sel-edgeᵢ=1 (Figure 4), on a H2 = CLK. La bascule esclave de la deuxième paire est séquencée par l'horloge de référence. Sa sortie Qe2 fournit le signal de synchronisation synchrone SYNC-outⱼ à transmettre en sortie OUT.

Le chronogramme de la figure 3 correspond au cas où Sel-edgeᵢ a été fixé à 0 pour ce convertisseur, indiquant que le niveau actif (1) du signal SYNC_inⱼ qui sera (est) reçu, est stable au moment d'un front descendant de l'horloge CLK : la détection par la première paire se fait sur un front descendant de CLK et la synchronisation par la deuxième paire est réalisée sur le front montant suivant de CLK.

Le chronogramme de la figure 4 correspond au cas inverse où Sel-edgeᵢ a été fixé à 1, indiquant que le niveau actif (1) du signal SYNC-inⱼ qui sera (est) reçu, est stable au moment d'un front montant de l'horloge CLK : la détection par la première paire se fait sur un front montant de CLK et la synchronisation par la deuxième paire est réalisée sur le front descendant suivant de CLK.

On note que dans les deux cas la détection et l'alignement sont réalisés sur une période d'horloge de référence.

### CIRCUIT LS2 ET PARAMETRE DE PHASE

On a vu que le paramètre de phase Sel-shiftⱼ est le paramètre qui permet de faire démarrer en phase les diviseurs de fréquence des convertisseurs. Si les convertisseurs sont formés chacun avec un unique coeur de conversion dont la fréquence d'échantillonnage est la fréquence d'horloge CLK, ce paramètre est fixé à sa valeur par défaut (zéro) dans tous les convertisseurs. Lorsque les convertisseurs sont formés chacun avec n coeurs de conversion, n entier au moins égal à 2, l'horloge d'échantillonnage des coeurs de conversion est fournie par un diviseur par un facteur n de la fréquence de l'horloge CLK.

Lors du processus de synchronisation, les diviseurs de fréquence des convertisseurs ne vont pas être réinitialisés sur le même front actif d'horloge CLK, mais de manière différée en lien avec la propagation du signal de synchronisation d'un convertisseur à l'autre. Mais le paramètre de phase assure qu'ils sont réinitialisés sur des fronts actifs d'horloge qui considérés deux à deux, sont distants d'un nombre qui est multiple de n périodes horloge CLK. De cette façon, les horloges d'échantillonnage démarrent toutes en phase.

Le paramètre de phase est appliqué au deuxième circuit LS2 du circuit de synchronisation du convertisseur. Il reçoit en entrée le signal SYNC-outⱼ fourni par le premier circuit LS1 ; il fournit en sortie le signal SYNC-Coreⱼ appliqué pour réinitialiser le générateur d'horloge d'échantillonnage Feⱼ (diviseur de fréquence) utilisée dans le ou les coeurs du convertisseur.

Le circuit LS2 comprend en pratique n-1 circuits à retard, par exemple des bascules D séquencées par le signal d'horloge CLK, chaque circuit retardant d'une période horloge CLK le signal reçu en entrée ; et un multiplexeur à n voies d'entrée et une voie de sortie, commandé par le paramètre de phase Sel-shift_{j.} Ce multiplexeur reçoit en entrées le signal SYNC-Coreⱼ et la sortie de chacun des n-1 circuits à retard, et sélectionne la voie d'entrée qui correspond au décalage fixé par le paramètre Sel-shiftⱼ.

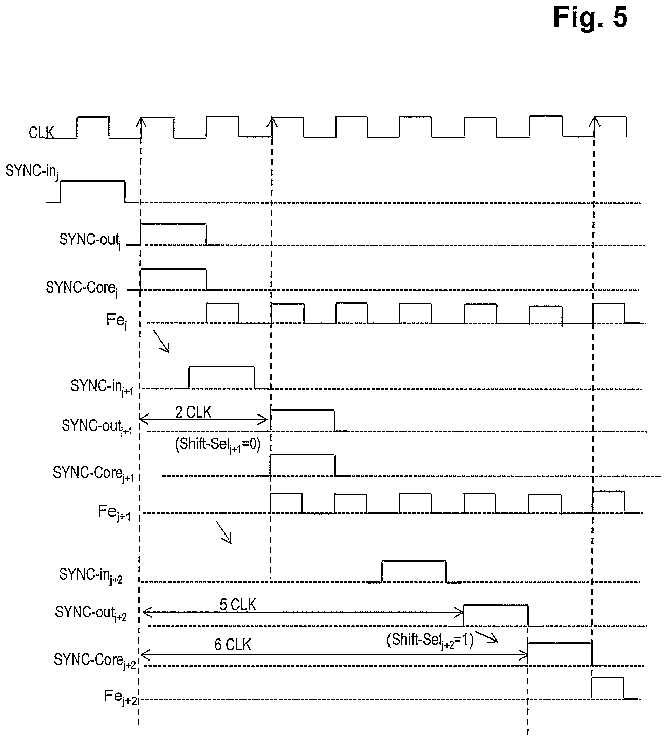

Le chronogramme de la figure 5 illustre les effets du circuit LS2 et du paramètre de phase. Il représente les signaux de synchronisation d'entrée (SYNC-inⱼ), de sortie (SYNC-outⱼ) et de coeur (SYNC-Coreⱼ) de trois convertisseurs successifs de la chaine, qui sont à n=2 coeurs travaillant à fréquence moitié de la fréquence d'horloge CLK. Dans ce chronogramme, on prend le signal de synchronisation de sortie SYNC-outⱼ du convertisseur le plus amont, CNⱼ comme référence. Pour les deux convertisseurs CNⱼ et CNj₊₁, les fronts actifs de leur signaux de sortie SYNC-outⱼ et SYNC-outⱼ₊₁ sont distants de 2 périodes horloge CLK : ces deux signaux peuvent être appliqués sans décalage (Sel-shiftⱼ et Sel-shiftⱼ₊₁ à 0) : leurs horloges d'échantillonnage Feⱼ démarreront en phase. Pour les deux convertisseurs CNⱼ et CNj₊₂, les fronts actifs de leurs signaux de sortie SYNC-outⱼ et SYNC-outⱼ₊₂ sont distants de 5 périodes horloge CLK, qui n'est pas multiple de 2. Dans l'exemple, on ajoute alors un décalage de 1 période horloge CLK au signal SYNC-outⱼ₊₂, pour arriver à un nombre multiple de 2 (en fixant le paramètre de phase Sel-shiftj₊₂ du convertisseur CNⱼ₊₂ à la valeur 1). Ainsi les horloges de ces trois convertisseurs Feⱼ, Feⱼ₊₁ et Feⱼ₊₂ démarreront toutes en phase, comme illustré sur la figure 5. On détermine ainsi la valeur du paramètre de phase de chaque convertisseur par rapport à un convertisseur amont dans la chaine.

### CIRCUIT LS3 ET BIT DRAPEAU

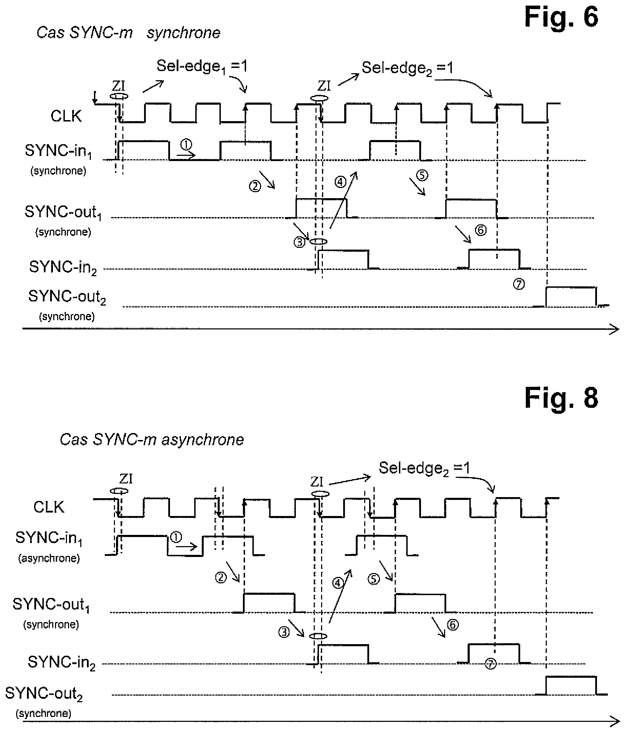

Le bit drapeau Flagⱼ du registre de configuration d'un convertisseur permet de signaler à l'unité de commande que l'acquisition du signal de synchronisation d'entrée SYNC-inⱼ n'est pas fiable, c'est-à-dire que le front d'horloge CLK défini par le paramètre de polarité pour la détection du niveau actif de ce signal (circuit LS1) tombe dans une zone où ce signal est instable, et qu'il faut donc le modifier. La figure 6 illustre cette situation : le front actif d'impulsion du signal SYNC-in₁ est concomitant avec le front d'horloge CLK fixé par le paramètre Sel-edge₁ pour la détection, qui à ce moment est le front descendant. On est dans une zone d'instabilité ZI du signal et la détection à ce moment n'est pas fiable. Le troisième circuit LS3 du circuit de synchronisation du convertisseur permet de détecter cette situation, et d'activer le cas échéant le bit drapeau Flagⱼ.

Ce circuit LS3 comprend en pratique trois étages de détection qui reçoivent chacun le signal de synchronisation d'entrée, SYNC-inⱼ et qui sont séquencés à partir de l'horloge de référence CLK. Un premier étage est configuré pour effectuer la détection d'un niveau actif du signal SYNC-inⱼ sur le front d'horloge CLK déterminé par la valeur par défaut du paramètre de polarité Sel-edgeⱼ. Les deux autres étages effectuent cette détection l'un sur un front légèrement en avance sur ce front d'horloge (-Δ), l'autre légèrement en retard (+Δ). Pour les fréquences élevées qui nous occupent, ce léger retard positif ou négatif est typiquement de l'ordre d'une dizaine de picosecondes (10⁻¹²s). Si les trois étages fournissent la même valeur logique en sortie correspondant au niveau actif du signal, c'est que ce niveau est bien établi au moment du front de détection. Si l'un au moins fourni une valeur logique différente, c'est que le signal SYNC-inⱼ était en train de s'établir à la valeur haute (ou basse) : on est dans une zone d'instabilité ZI. Le circuit LS3 active alors le bit drapeau Flagⱼ dans le registre de configuration, dans l'exemple en le positionnant à la valeur 1. En pratique les différents étages de détection sont conçus sensiblement comme l'étage de détection du circuit LS1, en incluant en outre des circuits à retard pour générer les fronts de détection en avance et en retard sur le front d'horloge de référence. Ce bit drapeau est notamment utilisé en phase d'apprentissage pour modifier la valeur du paramètre de polarité du convertisseur. Une autre utilisation est décrite ci-après, dans le processus de synchronisation de la chaine de convertisseurs.

### PROCESSUS DE SYNCHRONISATION DE LA CHAINE DE CONVERTISSEURS

Pendant la phase d'apprentissage qui sera décrite plus loin, l'unité de commande UC mémorise les paramètres de polarité et de phase déterminés pour chaque convertisseur, par exemple en mémoire non volatile.

A chaque nouvelle mise sous-tension, l'unité de commande programme les registres de configuration de chacun des convertisseurs. Elle déclenche ensuite le processus de synchronisation des convertisseurs.

Dans un mode de réalisation, ce processus est déclenché par l'émission par l'unité de commande d'un signal de synchronisation SYNC-m qui est synchrone de l'horloge CLK, c'est-à-dire que l'impulsion est émise sur un front actif d'horloge CLK.

Grâce aux paramètres de polarité et de phase configurés pour chaque convertisseur, ce signal de synchronisation va se propager depuis le premier convertisseur jusqu'au dernier de chaque chaine de convertisseurs constituée selon l'invention, en générant au passage dans chaque convertisseur, un signal de synchronisation du ou des coeurs de conversion correctement positionné en sorte qu'à la fin du processus, toutes les horloges d'échantillonnage seront en phase, comme illustré par exemple par le chronogramme de la figure 5.

Dans une variante, on peut prévoir que le processus de synchronisation est déclenché par l'émission par l'unité de commande d'un signal de synchronisation SYNC-m qui est asynchrone. Dans ce cas, il existe une incertitude sur la détection de l'impulsion de synchronisation par le premier convertisseur CN₁ en entrée de chaine. Cette incertitude est levée en prévoyant que l'unité de commande vérifie l'état du bit drapeau de ce convertisseur CN₁ : S'il n'est pas activé, c'est que le niveau actif d'impulsion était bien établi de façon stable au moment du front de détection positionné par le paramètre de polarité. S'il est activé, l'unité de commande émet une nouvelle impulsion de synchronisation asynchrone. Dès que le premier convertisseur a correctement détecté l'impulsion de synchronisation d'entrée, comme il transmet en sortie un signal de synchronisation SYNC-out₁ qui est par construction synchrone, le processus de synchronisation peut se poursuivre dans les convertisseurs suivants, comme décrit supra avec un signal SYNC-m synchrone.

On prévoit avantageusement que la broche de sortie de synchronisation du dernier convertisseur de la chaine est rebouclée sur l'unité de commande : l'unité de commande a ainsi une indication de fin de la phase de synchronisation des convertisseurs de chaque chaine.

### PROCESSUS D'APPRENTISSAGE DES PARAMETRES DE CONFIGURATION

Pour chaque chaine de convertisseurs constituée selon l'invention, il faut une phase d'apprentissage, pour configurer dans chaque convertisseur, les paramètres de polarité et de phase pour le processus de synchronisation. Après mise sous-tension du système, les convertisseurs sont initialisés : en particulier les registres de configuration des convertisseurs sont initialisés à une valeur par défaut, qui est généralement la valeur nulle. Dans tous les convertisseurs on a donc : Sel-edgeⱼ=0 et Sel-shiftⱼ=0. Avec les conventions retenues, cela signifie que dans les circuits LS1 de tous les convertisseurs, le front d'horloge CLK pour la détection est le front descendant ; et les circuits LS2 de tous les convertisseurs sélectionnent la voie d'entrée de synchronisation sans décalage.

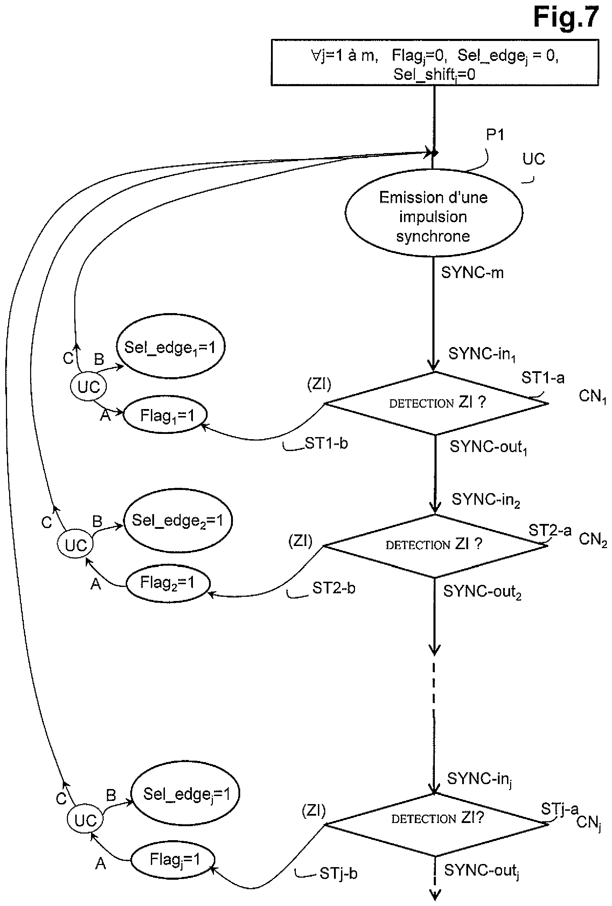

L'unité de commande est configurée pour activer une séquence d'apprentissage P1, pour déterminer pas à pas les paramètres de polarité des convertisseurs, comme illustré par le chronogramme de la figure 6 et le diagramme d'étapes de la figure 7.

La phase débute par l'émission d'un signal de synchronisation SYNC-m (une impulsion) synchronisé sur un front actif d'horloge CLK. L'unité de commande se met alors à l'écoute des convertisseurs pour détecter si un bit drapeau est activé.

Au niveau des convertisseurs, la séquence se déroule comme suit :

L'impulsion de synchronisation émise par l'unité de commande arrive en entrée de chaine sur le premier convertisseur CN₁ après un délai (que l'on n'a pas besoin de connaître) qui est fixe et qui ne dépend que des caractéristiques du chemin de conduction du signal depuis la sortie OUT-sync de l'unité de commande jusqu'à l'entrée IN de ce convertisseur (Figure 1). Le convertisseur effectue la détection du signal SYNC-in₁ reçu en entrée (circuit LS1) et vérifie (circuit LS3) si cette détection est faite dans une zone d'instabilité ZI de ce signal. (étape ST-a). Si ce n'est pas le cas, le signal se propage au convertisseur suivant, CN₂.

Mais si, comme illustré sur la figure 6, le délai de propagation entre la sortie OUT-sync de l'unité de commande et l'entrée IN de ce convertisseur est tel que le niveau haut du signal SYNC-in₁ s'établit autour ou au moment du front de détection, le front descendant dans l'exemple, qui est le front d'horloge CLK qui a la polarité définie par la valeur par défaut du paramètre de polarité Sel-edge₁, le convertisseur (par son circuit LS3) active son bit drapeau Flag₁ (étape ST-b).

L'unité de commande va alors détecter l'activation du bit drapeau Flag₁ du registre de configuration du convertisseur CN₁ et va :
- le remettre à zéro (étape A);
- positionner à 1 le paramètre de polarité Sel-edge₁ (étape B) _{;} et
- lancer une nouvelle séquence de synchronisation P1 (étape C).

Un nouveau signal de synchronisation SYNC-m synchrone est alors émis vers le premier convertisseur de la chaine comme illustré en ① sur la figure 6. Cette fois-ci, le paramètre de polarité du premier convertisseur est positionné de manière adéquate : l'impulsion de synchronisation est détectée de manière fiable et le convertisseur transmet en sortie une impulsion resynchronisée sur le front actif d'horloge CLK, SYNC-out₁, comme illustré en ② sur la figure 6.

Comme précédemment, l'impulsion de synchronisation arrive en entrée du deuxième convertisseur CN₂ après un délai déterminé qui ne dépend que des caractéristiques du chemin de conduction du signal depuis la sortie du convertisseur précédent jusqu'en entrée de ce convertisseur.

A son tour, ce convertisseur CN₂ effectue la détection du signal SYNC-in₂ reçu en entrée (circuit LS1) et vérifie (circuit LS3) si cette détection est faite dans une zone d'instabilité ZI de ce signal (étape ST-a). Si ce n'est pas le cas, le signal se propage au convertisseur suivant, CN₃.

Dans l'exemple, comme illustré en ③ sur la figure 6, le convertisseur détecte une zone ZI d'instabilité pour la polarité définie par le paramètre SEL-edge₂ (circuit LS3) et active son bit drapeau Flag₂ (étape ST-b).

Comme vu précédemment, l'unité de commande détecte cela, remet à zéro ce bit drapeau Flag₂ (étape A) ; positionne à 1 la valeur du paramètre de polarité Sel-edge₂ du convertisseur CN₂ (étape B) ; et active une nouvelle séquence de synchronisation P1 (étape C).

Un nouveau signal de synchronisation SYNC-m synchrone est émis, comme illustré en ④ sur la figure 6.

Cette fois-ci, le signal de synchronisation va être correctement détecté et transmis par les deux premiers convertisseurs déjà paramétrés. Le délai de propagation de l'impulsion de synchronisation depuis l'émission jusqu'à l'entrée du troisième convertisseur est ainsi bien déterminé, fixé. On peut alors déterminer le paramètre de polarité adéquat pour ce troisième convertisseur comme décrit précédemment. Et on détermine ainsi le paramètre de polarité adéquat pour chaque convertisseur successif dans la chaine, jusqu'au dernier.

On note que ce processus d'apprentissage est compatible avec un processus de synchronisation initié par l'unité de commande par un signal de synchronisation SYNC-m qui est synchrone ou asynchrone, comme il a été décrit supra.

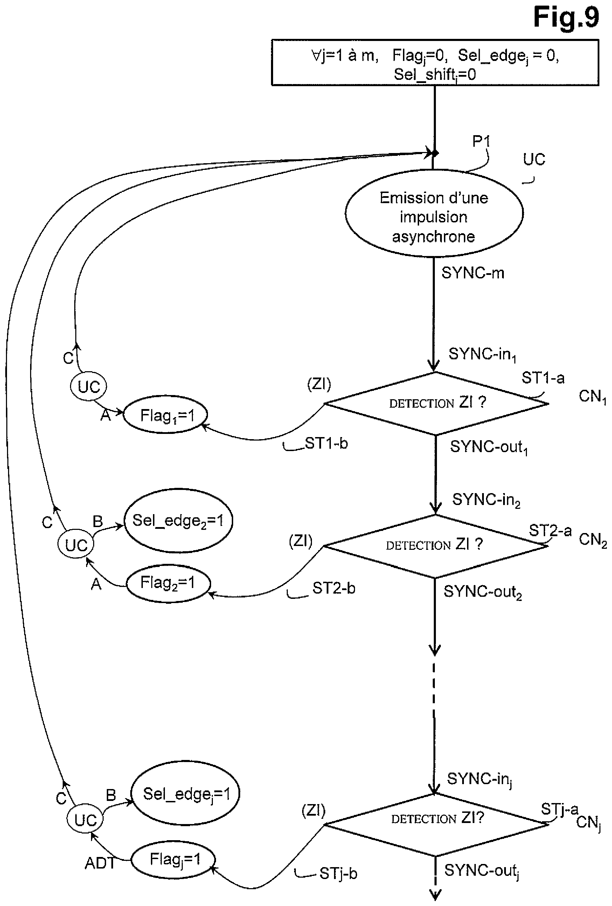

Les figures 8 et 9 illustrent une variante de la séquence d'apprentissage, dans laquelle l'unité de commande émet un signal de synchronisation SYNC-m asynchrone. Dans ce cas, l'unité de commande ne modifie pas le paramètre de polarité du premier convertisseur CN₁, si son bit drapeau est activé ; elle réinitialise le bit drapeau et émet un nouveau signal de synchronisation SYNC-m asynchrone et elle répète cela jusqu'à ce que le premier convertisseur arrive à détecter correctement le signal qu'il reçoit en entrée. La séquence est inchangée pour les autres convertisseurs de la chaine. On note que ce processus d'apprentissage n'est compatible qu'avec un processus de synchronisation initié par l'unité de commande par un signal de synchronisation SYNC-m également asynchrone.

Une fois que tous les paramètres de polarité ont été configurés, on peut alors effectuer la configuration des paramètres de phase Sel-shiftⱼ, des convertisseurs de la chaine. En effet, tous les délais de propagation du signal de synchronisation dans la chaine deviennent déterministes : les détections sont fiables et les signaux de synchronisation en sortie OUT des convertisseurs sont tous synchronisés sur un front actif d'horloge CLK. On peut donc déterminer le nombre de périodes horloges CLK séparant le front d'impulsion de synchronisation en sortie de chaque convertisseur d'un front d'impulsion de synchronisation en sortie d'un autre convertisseur, et ceci pour toute la chaine. Le principe est, comme illustré sur la figure 5, de mesurer l'écart entre les fronts d'impulsion de synchronisation en sortie de deux convertisseurs, et lorsque cet écart est égal à un nombre entier M de périodes horloge CLK qui n'est pas multiple de n, la valeur du paramètre de phase du convertisseur le plus aval, est fixé à la valeur p tel que M+p est un multiple de n. p peut donc être fixé à 0, 1, ... n-1.

Ceci peut se faire de différentes manières par exemple par observation, à l'oscilloscope, des signaux de sortie ou des signaux de synchronisation. Ou par calcul précis du délai de propagation entre la sortie OUT d'un convertisseur et l'entrée IN du convertisseur suivant, tenant compte du matériau de conducteur, de sa longueur, des caractéristiques des soudures, des caractéristiques des étage d'entrée et sortie, .... Ou encore en utilisant des séquences de tests générés par les convertisseurs. Cette détermination n'est pas réalisée par un processus automatique géré par l'unité de commande, comme pour le paramètre de polarité. Mais lorsque cette détermination est faite, on mémorise dans l'unité de commande, la valeur du paramètre de phase ainsi déterminée pour chaque convertisseur. Ces valeurs sont utilisées pour configurer les convertisseurs à chaque mise sous tension du système.

Le registre de configuration de chaque convertisseur comprend ainsi en pratique 1 bit réservé pour le bit drapeau, 1 bit réservé pour le paramètre de polarité et r bits, avec n=2^{r}, réservé pour le paramètre de phase.

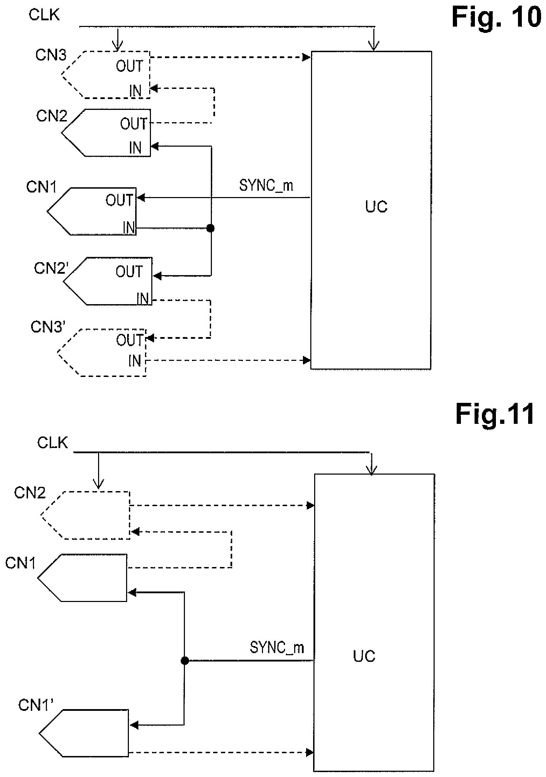

L'invention qui vient d'être décrite s'accommode aisément de toutes les formes d'arrangement des convertisseurs que l'on peut trouver dans les architectures de traitement de données dans les différents domaines applicatifs : arrangement série, parallèle, arborescence à plusieurs branches ..., ou combinaisons de ces arrangements. Les figures 10 et 11 donnent de tels exemples de configuration en arbre (figure 10) ou mixte (figure 11). Le procédé de synchronisation et le procédé d'apprentissage associé qui ont été expliqués s'appliquent de la même façon sur chacune des chaines d'un ou plusieurs convertisseurs constituées dans ces systèmes.

Elle ne se limite pas à des architectures utilisant un bus SPI en comme bus d'interface maitre esclave entre l'unité de commande et les convertisseurs.

## Revendications

1. Procédé de synchronisation de convertisseurs de données de type numérique/analogique et/ou analogique/numérique sur un front actif d'une horloge de référence CLK commune, **caractérisé en ce que** les convertisseurs forment au moins une chaine de transmission série d'un signal de synchronisation (SYNC-m) émis par une unité de commande (UC) des convertisseurs tel que :
- le convertisseur (CN₁) de rang 1 dans la chaine a une entrée de synchronisation (IN) connectée à une sortie de commande de synchronisation (OUT-sync) de l'unité de commande ;
- chaque convertisseur (CNⱼ) de rang j supérieur à 1 dans la chaine a une entrée de synchronisation (IN) connectée à la sortie de synchronisation (OUT) du convertisseur de rang j-1 (CNⱼ₋₁) dans la chaine ;
le procédé de synchronisation étant **caractérisé en ce qu'**un processus de synchronisation des convertisseurs de la chaine sur un front actif d'horloge de référence activé par l'unité de commande comprend les étapes suivantes pilotées par l'unité de commande:
- initialisation dans chaque convertisseur d'un registre de configuration de la synchronisation (REGⱼ) comportant au moins un paramètre de polarité (Sel-Edgeⱼ) définissant comme polarité d'un front d'horloge de référence (CLK) pour la détection de signal en entrée de synchronisation (IN) du convertisseur, la polarité du front actif d'horloge de référence ou la polarité inverse; puis
- émission sur la sortie de commande synchronisation (SYNC-out) de l'unité de commande d'un signal de synchronisation (SYNC-m), qui est une impulsion de largeur au moins égale à une période d'horloge de référence;
le procédé de synchronisation étant encore **caractérisé en ce que** chaque convertisseur dans la chaine est configuré pour réaliser les étapes suivantes:
- a) détection d'un signal de synchronisation (SYNC_inⱼ) en entrée de synchronisation (IN), sur un front d'horloge de référence CLK qui a la polarité définie par la valeur dudit paramètre de polarité (Sel-Edgeⱼ) configuré dans le convertisseur,
- b) alignement sur le front actif d'horloge de référence suivant du signal détecté à l'étape a) pour fournir un signal de synchronisation aligné sur un front actif d'horloge de référence et application dudit signal (SYNC-outⱼ) sur la sortie de synchronisation (OUT) du convertisseur.

2. Procédé selon la revendication 1, dans lequel chaque convertisseur (CNj) dans la chaine est formé de n coeurs de conversion à une fréquence d'échantillonnage (Feⱼ) qui est fournie par un diviseur par n de la fréquence d'horloge de référence, où n est un entier non nul, et configuré pour réaliser à la suite de l'étape b), les étapes suivantes :
- c) décalage dudit signal de synchronisation aligné obtenu à l'étape b) par un nombre entier de période(s) d'horloge de référence (CLK) défini par la valeur d'un paramètre de phase (Sel-shiftⱼ) fourni par ledit registre de configuration du convertisseur ; et
-d) application du signal décalé obtenu (SYNC-Coreⱼ) comme signal de réinitialisation dudit diviseur de fréquence par n,
où ledit nombre entier défini par le paramètre de phase a une valeur comprise entre 0 et n-1, bornes incluses.

3. Procédé selon la revendication 1 ou 2, dans lequel chaque convertisseur dans la chaine est en outre configuré pour réaliser l'étape suivante :
e) vérification de la stabilité d'un niveau actif de signal (SYNC-inⱼ) reçu en entrée de synchronisation (IN) acquis sur le front d'horloge de référence défini à l'étape a) de détection par la valeur dudit paramètre de polarité, par comparaison de la première valeur acquise sur ledit front de détection, à au moins une deuxième valeur dudit signal acquise sur un front en avance, d'un délai déterminé, sur ledit front de détection et à au moins un troisième valeur dudit signal acquise sur un front en retard, d'un délai déterminé, sur ledit front de détection, et si les valeurs ne sont pas toutes identiques, activation d'un bit drapeau correspondant (Flagⱼ) dans ledit registre de configuration du convertisseur.

4. Procédé selon la revendication 3, **caractérisé en ce que** le bit drapeau du registre de configuration des convertisseurs est utilisé par l'unité de commande dans une phase d'apprentissage (P1) pour changer la valeur du paramètre de polarité dans chaque convertisseur d'une chaine, d'une première valeur binaire initialisée par défaut à une deuxième valeur binaire, et **en ce que** dans ladite phase d'apprentissage, l'unité de commande émet un nouveau signal de synchronisation à chaque activation d'un bit drapeau dans le registre de configuration d'un convertisseur de la chaine, ladite phase d'apprentissage permettant la configuration du paramètre de polarité de chaque convertisseur successivement depuis le premier convertisseur en entrée de chaine, jusqu'au dernier convertisseur de la chaine.

5. Procédé selon la revendication 4, **caractérisé en ce qu'**après ladite étape d'apprentissage des paramètres de polarité des convertisseurs, on détermine une valeur p du paramètre de phase de chaque convertisseur, à partir d'une détermination du nombre entier M de périodes horloge de référence séparant le front d'impulsion de synchronisation en sortie (OUT) du convertisseur du front d'impulsion de synchronisation en sortie d'un convertisseur en amont dans la chaine, et la valeur p du paramètre de phase est telle que la somme M+p est un multiple de n.

6. Procédé selon l'une quelconque des revendications précédentes, **caractérisé en ce que** le signal de synchronisation (SYNC-m) émis par l'unité de commande est un signal synchronisé sur un front actif de l'horloge de référence CLK.

7. Procédé selon l'une quelconque des revendications précédentes, **caractérisé en ce que** le processus de synchronisation des convertisseurs de la chaine comprend l'émission par l'unité de commande d'un signal de synchronisation (SYNC-m) asynchrone et **en ce que** l'unité de commande émet un nouveau signal de synchronisation asynchrone à chaque activation du bit drapeau dans le registre de configuration du convertisseur (CN₁) de rang 1 en entrée de la chaine.

8. Convertisseur de données de type analogique/numérique ou numérique/analogique comprenant une entrée (IN) pour recevoir un signal de synchronisation et un circuit de synchronisation associé permettant la synchronisation du convertisseur sur un front actif d'un signal d'horloge de référence (CLK), **caractérisé en ce que** le convertisseur comprend un registre de configuration (REGⱼ) accessible en lecture/écriture via un bus d'interface par une unité de commande (UC) du convertisseur, ledit registre comprenant au moins un paramètre de polarité (SEL-edgeⱼ) pour définir une polarité de front d'horloge de référence pour la détection dudit signal de synchronisation (SYNC-inj) reçu en entrée, et **en ce que** le circuit de synchronisation comprend un circuit de détection (LS1) qui comprend :
- a) un étage de détection d'un niveau actif dudit signal de synchronisation reçu sur un front d'horloge de référence (CLK) qui a la polarité définie par la valeur binaire dudit paramètre de polarité (Sel_edgeⱼ), et
- b) un étage d'alignement du signal de synchronisation détecté par l'étage de détection qui fournit en sortie (Qe2) un signal de synchronisation aligné sur un front actif d'horloge de référence (CLK), et ledit signal de synchronisation aligné (SYNC-outⱼ) est appliqué sur une sortie de synchronisation (OUT) du convertisseur.

9. Convertisseur selon la revendication 8, qui est formé de n coeurs de conversion à une fréquence d'échantillonnage (Feⱼ) qui est fournie par un diviseur par n de la fréquence d'horloge de référence, où n est un entier non nul, **caractérisé en ce que** le registre de configuration comprend un autre paramètre de phase (Sel-shiftⱼ) dont la valeur est égale à un nombre entier compris entre 0 et n-1, bornes incluses, et **en ce que** le circuit de synchronisation comprend un circuit de décalage (LS2) configuré pour appliquer au signal fourni en sortie (Qe2) dudit étage d'alignement, un décalage d'un nombre entier de périodes d'horloge de référence (CLK), qui est donné par la valeur dudit paramètre de phase, et appliquer le signal décalé obtenu (SYNC-Coreⱼ) comme signal de réinitialisation du diviseur de fréquence par n.

10. Convertisseur selon la revendication 8 ou 9, dans lequel le circuit de synchronisation comprend un circuit (LS3) de vérification de la stabilité d'un niveau actif du signal de synchronisation (SYNC-inⱼ) reçu en entrée (IN), qui comprend un premier étage d'acquisition d'un niveau dudit signal de synchronisation (SYNC-inj) sur un front d'horloge de référence ayant la polarité définie par la valeur dudit paramètre de polarité, au moins un deuxième étage d'acquisition d'un niveau dudit signal de synchronisation (SYNC-inj) sur un front en avance, d'un délai déterminé, sur ledit front d'horloge de référence défini dans le premier étage et au moins un troisième étage d'acquisition d'un niveau dudit signal de synchronisation (SYNC-inj) sur un front en retard, d'un délai déterminé, sur ledit front d'horloge de référence défini dans le premier étage, et si les valeurs fournies par les différents étages ne sont pas toutes identiques, la sortie du dit circuit de vérification active un bit drapeau (Flagⱼ) dans ledit registre de configuration du convertisseur.

## Patentansprüche

1. Verfahren zur Synchronisation von Datenwandlern des Typs digital/analog und/oder analog/digital auf einer aktiven Anstiegsflanke eines gemeinsamen Referenztakts CLK, **dadurch gekennzeichnet, dass** die Wandler mindestens eine serielle Übertragungskette eines durch eine Steuerungseinheit (UC) der Wandler ausgegebenen Synchronisationssignals (SYNC-m) bilden, wie zum Beispiel:
- der Wandler (CN₁) mit Platz 1 in der Kette weist einen mit einem Ausgang der Synchronisationssteuerung (OUT-sync) der Steuerungseinheit verbundenen Synchronisationseingang (IN) auf;
- jeder Wandler (CNⱼ) mit Platz j größer als 1 in der Kette weist einen mit dem Synchronisationsausgang (OUT) des Wandlers mit Platz j-1 (CNⱼ₋₁) in der Kette verbundenen Synchronisationseingang (IN) auf;
wobei das Synchronisationsverfahren **dadurch gekennzeichnet** wird, dass ein Synchronisationsvorgang der Wandler der Kette auf einer durch die Steuerungseinheit aktivierten aktiven Anstiegsflanke des Referenztakts die durch die Steuerungseinheit gesteuerten folgenden Schritte umfasst:
- Initialisierung eines Konfigurationsregisters der Synchronisation (REGⱼ) in jedem Wandler, das mindestens einen Polaritätsparameter (Sel-Edgeⱼ) aufweist, der als Polarität einer Anstiegsflanke eines Referenztakts (CLK) für die Signalerfassung am Synchronisationseingang (IN) des Wandlers die Polarität der aktiven Anstiegsflanke des Referenztakts oder die umgekehrte Polarität definiert; dann
- Übertragung über den Ausgang der Synchronisationssteuerung (SYNC-out) der Steuerungseinheit eines Synchronisationssignals (SYNC-m), das ein Impuls mit einer Breite von mindestens gleich einer Periode des Referenztakts ist;
wobei das Synchronisationsverfahren noch **dadurch gekennzeichnet** wird, dass jeder Wandler in der Kette konfiguriert wird, die folgenden Schritte durchzuführen:
- a) Erfassung eines Synchronisationssignals (SYNC_inⱼ) im Synchronisationseingang (IN) auf einer Anstiegsflanke des Referenztakts CLK, die die Polarität aufweist, die durch den Wert des in dem Wandler konfigurierten Polaritätsparameters (Sel-Edgeⱼ) definiert wird,
- b) Ausrichtung auf die nächste aktive Anstiegsflanke des Referenztakts des im Schritt a) erfassten Signals, um ein auf eine aktive Anstiegsflanke des Referenztakts ausgerichtetes Synchronisationssignal bereitzustellen und Anwendung des Signals (SYNC-outⱼ) auf den Synchronisationsausgang (OUT) des Wandlers.

2. Verfahren nach Anspruch 1, wobei jeder Wandler (CNj) in der Kette mit n Wandlungskernen mit einer Abtastfrequenz (Feⱼ) gebildet wird, die durch einen Teiler durch n der Frequenz des Referenztakts bereitgestellt wird, wobei n eine Ganzzahl ungleich Null ist und konfiguriert wird, im Anschluss an Schritt b) die folgenden Schritte durchzuführen:
- c) Versetzen des im Schritt b) erhaltenen ausgerichteten Synchronisationssignals um eine ganze Zahl einer bzw. mehrerer Periode(n) des durch den Wert eines Phasenparameters (Sel-shiftⱼ) definierten Referenztakts (CLK), der durch das Konfigurationsregister des Wandlers bereitgestellt wird; und
- d) Anwendung des als Neustartsignal des Frequenzteilers durch n erhaltenen versetzten Signals (SYNC-Coreⱼ),
wobei die durch den Phasenparameter definierte ganze Zahl einen Wert aufweist, der zwischen 0 und n-1 liegt, die Grenzwerte eingeschlossen.

3. Verfahren nach Anspruch 1 oder 2, wobei jeder Wandler in der Kette außerdem konfiguriert wird, den folgenden Schritt durchzuführen:
e) Überprüfung der Stabilität eines im Synchronisationseingang (IN) empfangenen aktiven Signalpegels (SYNC-inⱼ), der auf der im Schritt a) der Erfassung durch den Wert des Polaritätsparameters erfassten Anstiegsflanke des Referenztakts durch Vergleich des auf der Erfassungsanstiegsflanke erfassten ersten Werts, mindestens eines zweiten Werts des auf einer voreilenden Flanke erfassten Signals einer bestimmten Zeitdauer auf der Erfassungsanstiegsflanke und mindestens eines dritten Werts des auf einer nacheilenden Anstiegsflanke erfassten Signals einer bestimmten Zeitdauer auf der Erfassungsanstiegsflanke definiert wird, und wenn die Werte nicht alle identisch sind, Aktivierung eines entsprechenden Flagbits (Flagⱼ) in dem Konfigurationsregisters des Wandlers.

4. Verfahren nach Anspruch 3, **dadurch gekennzeichnet, dass** das Flagbit des Konfigurationsregisters der Wandler durch die Steuerungseinheit in einer Lernphase (P1) verwendet wird, um den Wert des Polaritätsparameters in jedem Wandler einer Kette von einem ersten standardmäßig initialisierten Binärwert in einen zweiten Binärwert zu ändern, und dass in der Lernphase die Steuerungseinheit ein neues Synchronisationssignal bei jeder Aktivierung eines Flagbits in das Konfigurationsregisters eines Wandlers der Kette abgibt, wobei die Lernphase die Konfiguration des Polaritätsparameters jedes Wandlers nacheinander von dem ersten Wandler im Eingang der Kette bis zum letzten Wandler der Kette ermöglicht.

5. Verfahren nach Anspruch 4, **dadurch gekennzeichnet, dass** nach dem Lernschritt der Polaritätsparameter der Wandler ein Wert p des Phasenparameters jedes Wandlers von einer Bestimmung der ganzen Zahl M der Perioden des Referenztakts bestimmt wird, die die Anstiegsflanke des Synchronimpulses im Ausgang (OUT) des Wandlers von der Anstiegsflanke des Synchronimpulses im Ausgang eines in der Kette vorgelagerten Wandlers trennen, und der Wert p des Phasenparameters derart ist, dass die Summe M+p ein Mehrfaches von n ist.

6. Verfahren nach einem der vorhergehenden Ansprüche, **dadurch gekennzeichnet, dass** das durch die Steuerungseinheit ausgegebene Synchronisationssignal (SYNC-m) ein auf einer aktiven Anstiegsflanke des Referenztakts CLK synchronisiertes Signal ist.

7. Verfahren nach einem der vorhergehenden Ansprüche, **dadurch gekennzeichnet, dass** der Synchronisationsvorgang der Wandler der Kette die Übertragung eines asynchronen Synchronisationssignals (SYNC-m) durch die Steuerungseinheit umfasst, und dass die Steuerungseinheit ein neues asynchrones Synchronisationssignal bei jeder Aktivierung des Flagbits in das Konfigurationsregister des Wandlers (CN₁) mit Platz 1 im Eingang der Kette ausgibt.

8. Datenwandler des Typs analog/digital oder digital/analog, umfassend einen Eingang (IN), um ein Synchronisationssignal zu empfangen, und eine zugehörige Synchronisationsschaltung, die die Synchronisation des Wandlers auf einer aktiven Anstiegsflanke eines Signals des Referenztakts (CLK) ermöglicht, **dadurch gekennzeichnet, dass** der Wandler ein zum Lesen/Schreiben über einen Schnittstellenbus durch eine Steuerungseinheit (UC) des Wandlers zugängliches Konfigurationsregisters (REGⱼ) umfasst, wobei das Register mindestens einen Polaritätsparameter (SEL-edgeⱼ) umfasst, um eine Polarität der Anstiegsflanke des Referenztakts für die Erfassung des im Eingang empfangenen Synchronisationssignals (SYNC-inj) zu definieren, und dass die Synchronisationsschaltung eine Erfassungsschaltung (LS1) umfasst, die umfasst:
- a) eine Erfassungsstufe eines aktiven Pegels des auf einer Anstiegsflanke des Referenztakts (CLK) empfangenen Synchronisationssignals, das die durch den Binärwert des Polaritätsparameters (Sel_edgeⱼ) definierte Polarität aufweist, und
- b) eine Ausrichtungsstufe des durch die Erfassungsstufe erfassten Synchronisationssignals, die im Ausgang (Qe2) ein auf eine aktive Anstiegsflanke des Referenztakts (CLK) ausgerichtetes Synchronisationssignal bereitstellt, und wobei das ausgerichtete Synchronisationssignal (SYNC-outⱼ) auf einen Synchronisationsausgang (OUT) des Wandlers angewendet wird.

9. Wandler nach Anspruch 8, der aus n Wandlungskernen mit einer Abtastfrequenz (Feⱼ) gebildet wird, die durch einen Frequenzteiler durch n des Referenztakts bereitgestellt wird, wobei n eine Ganzzahl ungleich Null ist, **dadurch gekennzeichnet, dass** das Konfigurationsregister einen weiteren Phasenparameter (Sel-shiftⱼ) umfasst, dessen Wert gleich einer ganzen Zahl zwischen 0 und n-1 ist, die Grenzwerte eingeschlossen, und dass die Synchronisationsschaltung eine Versetzschaltung (LS2) umfasst, die konfiguriert wird, um auf das im Ausgang (Qe2) gelieferte Signal der Ausrichtungsstufe ein Versetzen einer ganze Zahl der Perioden des Referenztakts (CLK) anzuwenden, die durch den Wert des Phasenparameters bestimmt wird, und das erhaltene versetzte Signal (SYNC-Coreⱼ) als Neustartsignal des Frequenzteilers durch n anzuwenden.

10. Wandler nach Anspruch 8 oder 9, wobei die Synchronisationsschaltung eine Überprüfungsschaltung (LS3) der Stabilität eines im Eingang (IN) empfangenen aktiven Pegels des Synchronisationssignals (SYNC-inⱼ) umfasst, die eine erste Erfassungsstufe eines Pegels des Synchronisationssignals (SYNC-inⱼ) auf einer Anstiegsflanke des Referenztakts umfasst, aufweisend die durch den Wert des Polaritätsparameters definierte Polarität, mindestens eine zweite Erfassungsstufe eines Pegels des Synchronisationssignals (SYNC-inⱼ) auf einer voreilenden Anstiegsflanke einer bestimmten Zeitdauer auf der in der ersten Stufe definierten Anstiegsflanke des Referenztakts und mindestens eine dritte Erfassungsstufe eines Pegels des Synchronisationssignals (SYNC-inj) auf einer nacheilenden Anstiegsflanke einer bestimmten Zeitdauer auf der Anstiegsflanke des in der ersten Stufe definierten Referenztakts, und wenn die durch die unterschiedlichen Stufen bereitgestellten Werte nicht alle identisch sind, aktiviert der Ausgang der Überprüfungsschaltung ein Flagbit (Flagⱼ) in dem Konfigurationsregister des Wandlers.

## Claims

1. Method for synchronizing digital/analogue and/or analogue/digital data converters to an active front of a common reference clock CLK, **characterized in that** the converters form at least one series transmission chain of a synchronizing signal (SYNC-m) emitted by a control unit (UC), such that:
- the converter (CN₁) of rank 1 in the chain has a synchronization input (IN) connected to a synchronization control output (OUT-sync) of the control unit;
- each converter (CNⱼ) of rank j higher than 1 in the chain has a synchronization input (IN) connected to the synchronization output (OUT) of the converter of rank j-1 (CNⱼ₋₁) in the chain;
the synchronizing method being **characterized in that** a procedure for synchronizing the converters of the chain to a reference-clock active front activated by the control unit comprises the following steps, which are controlled by the control unit:
- a step of initializing, in each converter, a synchronization configuration register (REGⱼ) including at least one polarity parameter (Sel-Edgeⱼ) defining the polarity of a reference-clock (CLK) front for detection of signals input via the synchronization input (IN) of the converter as the polarity of the reference-clock active front or the inverse polarity; then
- sending to the synchronization control output (SYNC-out) of the control unit a synchronizing signal (SYNC-m), which is a pulse of width at least equal to one reference-clock period;
the synchronizing method also being **characterized in that** each converter in the chain is configured to carry out the following steps:
- a) a step of detecting, on a CLK reference-clock front, that front has the polarity defined by the value of said polarity parameter (Sel-Edgeⱼ) configured in the converter, a synchronizing signal (SYNC_inⱼ) input via the synchronization input (IN),
- b) a step of aligning with the following reference-clock active front the signal detected in step a), so as to deliver a synchronizing signal aligned with a reference-clock active front, and applying said signal (SYNC-outⱼ) to the synchronization output (OUT) of the converter.

2. Method according to Claim 1, wherein each converter (CNⱼ) in the chain is formed from n cores converting at a sampling frequency (Feⱼ) that is delivered by a divider by n of the reference-clock frequency, where n is a nonzero integer, and configured to carry out, following step b), the following steps:
- c) a step of shifting said aligned synchronizing signal obtained in step b) by an integer number of reference-clock (CLK) period(s), which integer number is defined by the value of a phase parameter (Sel-shiftⱼ) delivered by said configuration register of the converter; and
- d) a step of using the obtained shifted signal (SYNC-Coreⱼ) as a signal for resetting said divider of frequency by n,
wherein said integer number defined by the phase parameter has a value comprised between 0 and n-1, inclusive of limits.

3. Method according to Claim 1 or 2, wherein each converter in the chain is furthermore configured to carry out the following step:
- e) a step of verifying the stability of an active level of the signal (SYNC-inⱼ) received via the synchronization input (IN) and acquired on the reference-clock front defined in the detecting step a) by the value of said polarity parameter, by comparing the first value acquired on said detecting front to at least one second value of said signal, which value is acquired on a front that is ahead, by a set time, on said detecting front and to at least one third value of said signal, which value is acquired on a front that is behind, by a set time, on said detecting front, and if the values are not all identical, activating a corresponding flag bit (Flagⱼ) in said configuration register of the converter.

4. Method according to Claim 3, **characterized in that** the flag bit of the configuration register of the converters is used by the control unit in a setting phase (P1) to change the value of the polarity parameter in each converter of a chain, from a first binary value initialized by default to a second binary value, and **in that**, in said setting phase, the control unit emits a new synchronizing signal each time a flag bit is activated in the configuration register of a converter of the chain, said setting phase allowing the polarity parameter of each converter, in succession from the first converter at the input of the chain to the last converter of the chain, to be configured.

5. Method according to Claim 4, **characterized in that** after said step of setting the polarity parameters of the converters, a value p of the phase parameter of each converter is determined on the basis of a determination of the integer number M of reference-clock periods separating the synchronizing pulse front output from the converter via its output (OUT) from the synchronizing pulse front output from an upstream converter in the chain, and the value p of the phase parameter is such that the sum M+p is a multiple of n.

6. Method according to any one of the preceding claims, **characterized in that** the synchronizing signal (SYNC-m) emitted by the control unit is a signal synchronized to an active front of the reference clock CLK.

7. Method according to any one of the preceding claims, **characterized in that** the procedure for synchronizing the converters of the chain comprises the emission, by the control unit, of an asynchronous synchronizing signal (SYNC-m) and **in that** the control unit emits a new asynchronous synchronizing signal each time the flag bit is activated in the configuration register of the converter (CN₁) of rank 1 at the input of the chain.

8. Analogue/digital or digital/analogue data converter comprising an input (IN) for receiving a synchronizing signal and an associated synchronizing circuit allowing the converter to be synchronized to an active front of a reference-clock (CLK) signal, **characterized in that** the converter comprises a configuration register (REGⱼ) that may be read from and written to via an interface bus by a control unit (UC) of the converter, said register comprising at least one polarity parameter (SEL-edgeⱼ) defining a reference-clock-front polarity for detection of said synchronizing signal (SYNC-inⱼ) received as input, and **in that** the synchronizing circuit comprises a detecting circuit (LS1) that comprises:
- a) a stage for detecting, an active level of said synchronizing signal, received on a reference-clock (CLK) front that has the polarity defined by the binary value of said polarity parameter (Sel_edgeⱼ), and
- b) a stage for aligning the synchronizing signal detected by the detecting stage, which delivers as output (Qe2) a synchronizing signal aligned with a reference-clock (CLK) active front, and said aligned synchronizing signal (SYNC-outj) is applied to a synchronization output (OUT) of the converter.

9. Converter according to Claim 8, which is formed from n cores converting at a sampling frequency (Feⱼ) that is delivered by a divider by n of the reference-clock frequency, where n is a nonzero integer, **characterized in that** the configuration register contains another phase parameter (Sel-shiftⱼ) the value of which is equal to an integer number comprised between 0 and n-1, inclusive of limits, and **in that** the synchronizing circuit comprises a shifting circuit (LS2) configured to apply to the signal delivered as output (Qe2) from said aligning stage, a shift of an integer number of reference-clock (CLK) periods, which is given by the value of said phase parameter, and to use the obtained shifted signal (SYNC-Coreⱼ) as a signal for resetting the divider of frequency by n.

10. Converter according to Claim 8 or 9, wherein the synchronizing circuit comprises a circuit (LS3) for verifying the stability of an active level of the synchronizing signal (SYNC-inⱼ) received via the input (IN), which comprises a first stage for acquiring a level of said synchronizing signal (SYNC-inⱼ) on a reference-clock front having the polarity defined by the value of said polarity parameter, at least one second stage for acquiring a level of said synchronizing signal (SYNC-inⱼ) on a front that is ahead, by a set time, on said reference-clock front defined in the first stage, and at least one third stage for acquiring a level of said synchronizing signal (SYNC-inⱼ) on a front that is behind, by a set time, on said reference-clock front defined in the first stage, and if the values delivered by the various stages are not all identical, the output of said verifying circuit activates a flag bit (Flagⱼ) in said configuration register of the converter.
